# EUROPÄISCHE PATENTSCHRIFT

(11) **EP 1 192 294 B1**
(45) Veröffentlichungstag und Bekanntmachung des Hinweises auf die Patenterteilung: **02.01.2003**
(21) Anmeldenummer: 00912321.7
(22) Anmeldetag: 04.04.2000
(51) Int. Cl.: C23C 16/44, C30B 25/14

(54) **KAMMER FÜR EINE CHEMISCHE DAMPFBESCHICHTUNG**
CHAMBER FOR CHEMICAL VAPOUR DEPOSITION
CHAMBRE POUR REALISER UN DEPOT CHIMIQUE EN PHASE VAPEUR

(30) Priorität: 28.04.1999 DE 19919326
(43) Veröffentlichungstag der Anmeldung: 03.04.2002
(73) Patentinhaber: Unaxis Trading AG, 9477 Trübbach (CH)
(72) Erfinder: BUSCHBECK, Martin, CH-9475 Sevelen (CH); SCHOLLER, Johann, D-64859 Eppertshausen (DE)
(74) Vertreter: Troesch Scheidegger Werner AG
(86) Internationale Anmeldenummer: CH0000194
(87) Internationale Veröffentlichungsnummer: WO00066805

(56) Entgegenhaltungen:
- DE-A- 19 745 185
- US-A- 4 123 989

## Beschreibung

Die Erfindung bezieht sich auf eine Kammer für eine chemische Dampfbeschichtung. Kammern zur chemischen Dampfbeschichtung sind bekannt. Unter der chemischen Dampfbeschichtung (CVD = Chemical Vapour Deposition) ist die Beschichtung einer beheizten Oberfläche mit einem Feststoff aus einer chemischen Reaktion in der Dampfphase zu verstehen. Aus dem Prospekt "SIRIUS A Low-Temperature Epitaxy UHV-CVD System" der LEYBOLD SYSTEMS GmbH, 1996, ist eine Kammer für eine chemische Dampfbeschichtung bekannt, die als Quarzrohr gestaltet ist. Die Kammer ist an ihrer einen Seite mit einer Pumpstation verbunden. Diese Pumpstation dient zur Einstellung des erforderlichen Vakuums in der Kammer. An ihrer anderen Seite ist die Kammer mit der Beschickungsstation verbunden, mit welcher die zu beschichtenden Substrate in die Kammer eingespeist werden. In der Praxis hat es sich bewährt, das Quarzrohr als Doppelmantelrohr auszubilden. Im Außenmantel wird dabei ein Stutzen angeordnet, mit welchem es möglich ist, zwischen dem Außen- und dem Innenrohr des Doppelmantelrohres ein Vakuum zu realisieren. Auf diese Weise ist das Innenrohr vorteilhaft vor Verunreinigungen geschützt, die sich aus prozeßtechnischen Gründen nicht auf dem Quarzrohr außen niederschlagen dürfen. Nachteilig ist dabei jedoch, daß dieser Stutzen relativ schnell ausbricht und es zum Aufbau von Spannungen im Doppelmantelrohr kommt, die sich nachteilig auf die gleichmäßige Erwärmung des Mittelteils des Doppelmantelrohres auswirken.

Der Erfindung liegt daher die Aufgabe zugrunde, eine Kammer für eine chemische Dampfbeschichtung zu schaffen, die eine relativ hohe Bruchfestigkeit aufweist und bei der die erforderlichen Anschlüsse nahezu spannungsfrei fixiert werden können.

Die der Erfindung zugrunde liegende Aufgabe wird durch eine Kammer für eine chemische Dampfbeschichtung gelöst, die aus einem inneren Quarzrohr besteht, das von einem kürzeren äußeren Quarzrohr umgeben ist, bei der jedes Ende des inneren Quarzrohres mit einem ersten Flansch umgeben ist, der eine in Längsrichtung des inneren Quarzrohres umlaufende Nut aufweist, in der jeweils die Stirnseite des inneren Quarzrohres positioniert ist, wobei zwischen dem ersten Flansch und der Außenseite des inneren Quarzrohres eine Dichtung angeordnet ist, und bei der an dem jeweiligen ersten Flansch in Richtung zur Rohrmitte ein zweiter Flansch angeordnet ist, der eine umlaufende Kante zur Fixierung der Stirnseite des kürzeren äußeren Quarzrohres aufweist und der sowohl an der Außenseite des inneren Quarzrohres als auch an der Außenseite des kürzeren äußeren Quarzrohres anliegt, wobei zwischen dem zweiten Flansch und der Außenseite des kürzeren äußeren Quarzrohres eine Dichtung angeordnet ist, und mindestens ein zweiter Flansch mindestens einen verschließbaren Anschluß aufweist, der mit dem Raum zwischen dem kürzeren äußeren Quarzrohr und dem inneren Quarzrohr verbunden ist, und bei der jeder erste Flansch und jeder zweite Flansch innen jeweils einen Kühlkanal mit jeweils mindestens einem Einlaß und einem Auslaß für ein Kühlmedium aufweisen. Die Kammer ist somit an beiden Seiten mit einem ersten Flansch versehen, der neben der Fixierung des inneren Quarzrohres auch zur Befestigung der Kammer an benachbarte Bauteile dient. Bei den Dichtungen handelt es sich um umlaufende Dichtungen. Die Verbindung zwischen dem ersten Flansch und dem in Richtung zur Rohrmitte benachbart angeordneten zweiten Flansch erfolgt beispielsweise mit einer Schraubenverbindung. Es hat sich in überraschender Weise gezeigt, daß sich die Bruchfestigkeit in vorteilhafter Weise erhöhen läßt und Spannungen weitgehend vermieden werden können, sofern auf eine direkte Verbindung zwischen dem kürzeren äußeren Quarzrohr und dem inneren Quarzrohr, die bei der Konstruktion eines Doppelmantelrohres gegeben ist, verzichtet wird. Durch den einen verschließbaren Anschluß, der mit dem Raum zwischen dem kürzeren äußeren Quarzrohr und dem inneren Quarzrohr verbunden ist, läßt sich der Raum zwischen dem inneren Quarzrohr und dem kürzeren äußeren Quarzrohr auf relativ einfache Weise evakuieren. Die Anordnung des verschließbaren Anschlusses, der in der Regel in Form eines Rohrstutzens ausgebildet ist, erfolgt direkt im zweiten Flansch, wobei es vorteilhaft sein kann, mehrere verschließbare Anschlüsse anzuordnen. Besonders vorteilhaft ist es dabei, die verschließbaren Anschlüsse senkrecht zur Längsachse des inneren Quarzrohres anzuordnen. Jeder erste Flansch und jeder zweite Flansch weist jeweils einen Kühlkanal auf, durch welchen ein Kühlmedium, beispielsweise eine Kühlflüssigkeit wie Wasser, geleitet wird. Das Kühlmedium dient zur Kühlung der angeordneten Dichtungen.

Eine bevorzugte Ausgestaltung der Erfindung besteht darin, daß mindestens ein erster Flansch mindestens einen verschließbaren Anschluß aufweist, der zur Innenseite des inneren Quarzrohres verläuft. Durch diese Maßnahme läßt sich an der Außenseite des inneren Quarzrohres direkt an dessen Ende ein Vakuum einstellen, was besonders dann vorteilhaft ist, wenn im Inneren der Kammer ein Ultrahochvakuum angelegt wird. Die Evakuierung erfolgt dann direkt durch den verschließbaren Anschluß, der in vorteilhafter Weise ebenfalls senkrecht zur Längsachse des inneren Quarzrohres positioniert werden kann.

Gemäß einer weiteren bevorzugten Ausgestaltung der Erfindung ist zwischen dem zweiten Flansch und der Außenseite des kürzeren äußeren Quarzrohres mindestens an einer Stelle eine Schicht aus Polytetrafluorethylen angeordnet. Auf diese Weise lassen sich das innere Quarzrohr und des kürzere äußeren Quarzrohr beim Zusammenbau an deren Enden störungsfrei jeweils im ersten Flansch und im zweiten Flansch anordnen. In der Regel ist es dabei vorteilhaft, zwei Schichten aus Polytetrafluorethylen anzuordnen. Diese Schichten wirken als Lager und stabilisieren die Kammer.

Nach einer weiteren bevorzugten Ausgestaltung der Erfindung sind die Abstände a zwischen der Stirnseite des inneren Quarzrohres und der an der gleichen Seite der Kammer verlaufenden Stirnseite des kürzeren äußeren Quarzrohres an beiden Seiten der Kammer jeweils gleich groß. Dies hat zur Folge, daß der erste Flansch und der zweite Flansch an beiden Seiten der Kammer nahezu gleichartig ausgebildet sein können, da die Abmessungen an den Rohrenden jeweils gleich sind. Die Flansche sind lediglich konstruktiv dem direkt benachbarten Anlagenteil, der Pumpstation oder der Beschickungsvorrichtung, anzupassen, was die Fertigung erleichtert. Durch die gleichzeitig erreichte mittige Anordnung des kürzeren äußeren Quarzrohres wird darüber hinaus die Einstellung einer homogenen Temperaturverteilung innerhalb der mittigen Heizzone gewährleistet.

Eine weitere bevorzugte Ausgestaltung der Erfindung besteht darin, daß der Abstand c zwischen dem jeweiligen zweiten Flansch und der mittig um die Kammer angeordneten Heizzone im Bereich von 60 mm bis 130 mm liegt. Ein Abstand c von 60 mm bis 130 mm hat sich für die meisten Einsatzfälle als besonders vorteilhaft erwiesen, da sich bei dessen Einhaltung auf einfachem Wege eine konstante Temperatur über die Länge der Heizzone realisieren läßt.

Gemäß einer weiteren bevorzugten Ausgestaltung der Erfindung weist der erste Flansch an mindestens einer Stelle einen parallel zur Längsrichtung des inneren Quarzrohres beweglich geführten Bolzen mit einer am ersten Flansch außen anliegenden Druckfeder auf, der mit einem benachbarten Anschlußflansch verbunden ist. Der benachbarte Anschlußflansch kann dabei ein Teil der Pumpstation oder ein Teil der Beschickungsvorrichtung sein. Die Anordnung mindestens eines Bolzens mit einer am ersten Flansch außen anliegenden Druckfeder erhöht die Anpreßkraft des ersten Flansches auf die Stirnseite des inneren Quarzrohres, was die Dichtigkeit erhöht.

Nach einer weiteren bevorzugten Ausgestaltung der Erfindung sind der erste Flansch und der in Richtung zur Rohrmitte angeordnete zweite Flansch als Einzelteil gefertigt, und die Kühlkanäle bilden einen einzigen gemeinsamen Kühlkanal. Dabei ist vorteilhaft, daß auf die Verbindung zwischen dem ersten Flansch und dem zweiten Flansch verzichtet werden kann. Dabei ist die vereinfachte Konstruktion vorteilhaft, besonders dann, wenn die Kammer für eine chemische Dampfbeschichtung besonders rasch gefertigt werden muß.

Eine weitere bevorzugte Ausgestaltung der Erfindung besteht darin, daß in der umlaufenden Nut eine weitere umlaufende Dichtung angeordnet ist. Auf diese Weise wird die Dichtigkeit der Kammer besonders vorteilhaft erhöht und die zwischen dem ersten Flansch und der Außenseite des inneren Quarzrohres angeordnete Dichtung entlastet.

Die Erfindung wird nachfolgend anhand der Zeichnung (Fig. 1 bis Fig. 3) näher und beispielhaft erläutert.
- Fig. 1: zeigt einen Teil der Kammer für die chemische Dampfbeschichtung im Querschnitt mit dem Anschluß an die Pumpstation;
- Fig. 2: zeigt einen Teil der Kammer für die chemische Dampfbeschichtung im Querschnitt mit dem Anschluß für die Beschickungsanlage;
- Fig. 3: zeigt die Kammer für eine chemische Dampfbeschichtung im Querschnitt, die an ihrem einen Ende mit einer Pumpstation und mit ihrem anderen Ende an die Beschickungsvorrichtung angeschlossen ist.

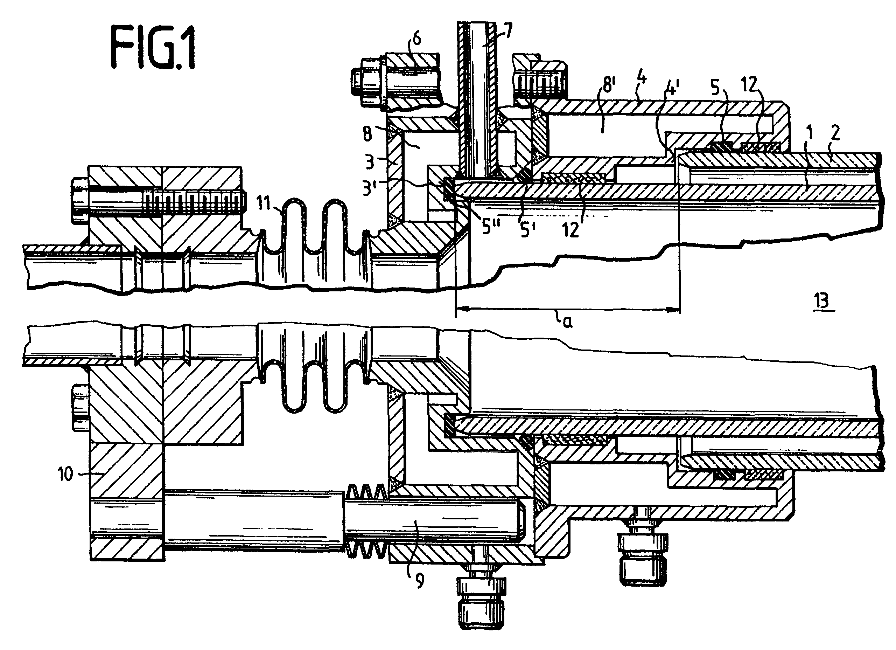

In Fig. 1 ist ein Teil der Kammer für eine chemische Dampfbeschichtung im Querschnitt dargestellt, die an eine Pumpstation angeschlossen ist. Die Kammer weist ein inneres Quarzrohr 1 auf, das von einem kürzeren äußeren Quarzrohr 2 umgeben ist. Das Ende des inneren Quarzrohres 1 ist mit einem ersten Flansch 3 umgeben, der eine in Längsrichtung des inneren Quarzrohres 1 umlaufende Nut 3' aufweist, in der die Stirnseite des inneren Quarzrohres 1 positioniert ist. Zwischen dem ersten Flansch 3 und der Außenseite des inneren Quarzrohres 1 ist eine Dichtung 5' angeordnet. An dem jeweiligen ersten Flansch 3 ist in Richtung zur Rohrmitte ein zweiter Flansch 4 angeordnet, der eine umlaufende Kante 4' zur Fixierung der Stirnseite des kürzeren äußeren Quarzrohres 2 aufweist und der sowohl an der Außenseite des inneren Quarzrohres 1 als auch an der Außenseite des kürzeren äußeren Quarzrohres 2 anliegt. Zwischen dem zweiten Flansch 4 und der Außenseite des kürzeren äußeren Quarzrohres 2 ist ebenfalls eine Dichtung angeordnet. Der erste Flansch 3 und der zweite Flansch 4 weisen innen jeweils einen Kühlkanal 8,8' mit jeweils mindestens einem Einlaß und einem Auslaß für ein Kühlmedium (nicht dargestellt) auf. Der erste Flansch 3 weist einen verschließbaren Anschluß 7 auf, der zur Innenseite des inneren Quarzrohres 1 verläuft. Der verschließbare Anschluß 7 ermöglicht die Einstellung eines Vakuums an der Außenseite des inneren Quarzrohres 1 an dessen Ende, was besonders dann von Vorteil ist, wenn im Inneren 13 der Kammer ein Ultrahochvakuum eingestellt wurde. Zwischen dem zweiten Flansch 4 und den Außenseiten des kürzeren äußeren Quarzrohres 2 und des inneren Quarzrohres 1 ist an zwei Stellen eine Schicht 12 aus Polytetrafluorethylen angeordnet. Diese Schichten 12, die als umlaufende Bänder in Nuten, die im zweiten Flansch 4 angeordnet sind, fixiert sind, wirken als Lager für das innere Quarzrohr 1 und für das kürzere äußere Quarzrohr 2 und dienen somit der Stabilisierung der Kammer. Zwischen den Stirnseiten des inneren Quarzrohres 1 und des kürzeren äußeren Quarzrohres 2 besteht ein Abstand a, der vorzugsweise an beiden Seiten der Kammer jeweils gleich groß sein sollte. Dies erleichtert die konstruktive Fertigung, da an beiden Seiten der Kammer nahezu baugleiche Flansche eingesetzt werden können. Parallel zur Längsrichtung des inneren Quarzrohres 1 ist im ersten Flansch 3 ein Bolzen 9 mit einer am ersten Flansch 3 außen anliegenden Druckfeder beweglich geführt, der mit dem benachbarten Anschlußflansch 10 der Pumpstation verbunden ist. Der Bolzen 9 mit einer am ersten Flansch 3 außen anliegenden Druckfeder verstärkt die Anpreßkraft an die Stirnseite des inneren Quarzrohres 1, was besonders dann vorteilhaft ist, wenn in der umlaufenden Nut 3' eine weitere umlaufende Dichtung 5'' angeordnet ist. Der erste Flansch 3 ist dabei über den Balg 11 mit dem Anschlußflansch 10 verbunden. Der Balg 11 kompensiert thermisch bedingte Längenausdehnungen wie die Feder auf dem beweglich geführten Bolzen 9. Der erste Flansch 3 und der zweite Flansch 4 sind über eine Schraubenverbindung 6 miteinander verbunden.

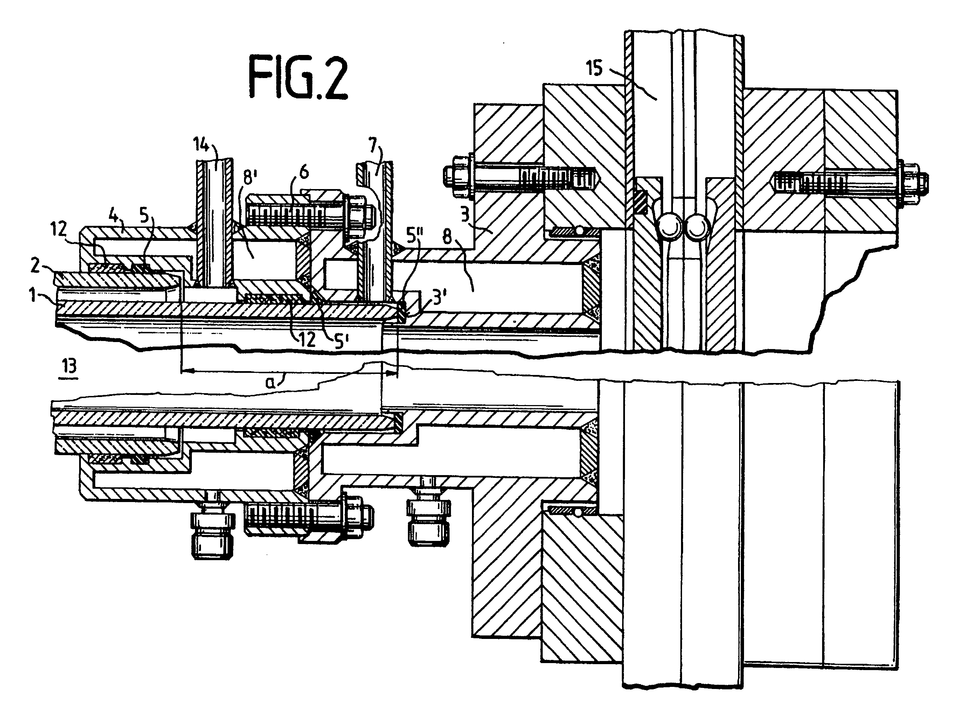

In Fig. 2 ist die Kammer für eine chemische Dampfbeschichtung im Querschnitt dargestellt, deren Ende mit einer Beschickungsvorrichtung verbunden ist. Der zweite Flansch 4 weist einen verschließbaren Anschluß 14 auf, der mit dem Raum zwischen dem kürzeren äußeren Quarzrohr 2 und dem inneren Quarzrohr 1 verbunden ist. Mit dem verschließbaren Anschluß 14 läßt sich der Raum zwischen dem inneren Quarzrohr 1 und dem kürzeren äußeren Quarzrohr 2 auf relativ einfache Weise evakuieren. Der erste Flansch 3 ist direkt mit dem Schieber 15 verbunden, der zur Beschickungsvorrichtung gehört und durch welchen die Beschickung der Kammer mit den Substraten erfolgt. In der Regel ist es vorteilhaft, den ersten Flansch 3 und den zweiten Flansch 4 als Einzelteil zu fertigen, so daß beispielsweise auf die Schraubenverbindung 6 verzichtet werden kann. Dabei ist es zweckmäßig, die Kühlkanäle 8,8' als einheitlichen einzigen gemeinsamen Kühlkanal auszubilden (nicht dargestellt).

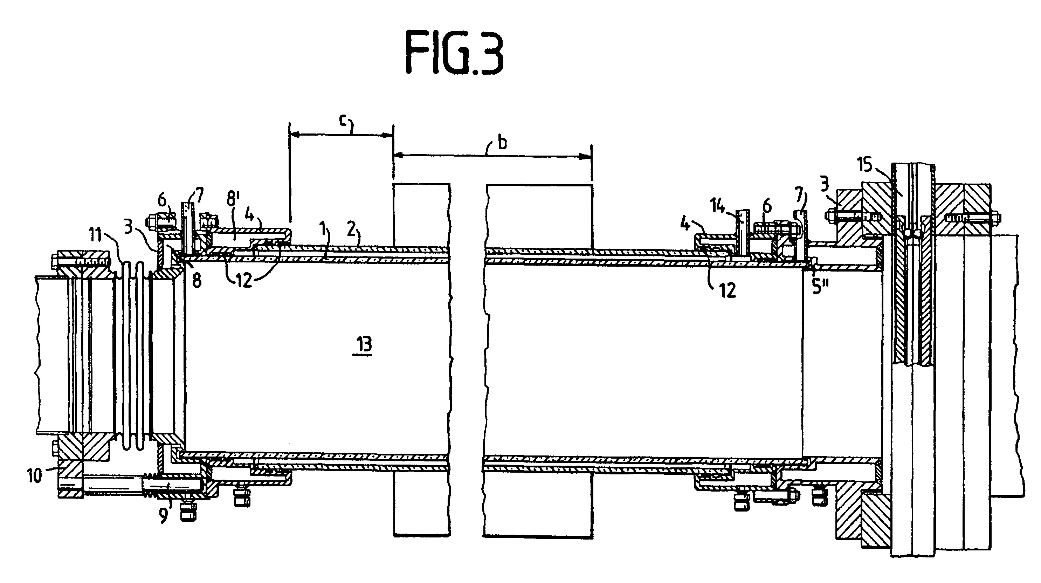

In Fig. 3 ist die Kammer für eine chemische Dampfbeschichtung im Querschnitt dargestellt, wobei das eine Ende über einen Anschlußflansch 10 mit einer Pumpstation verbunden ist und das andere Ende an eine Beschickungsvorrichtung mit einem Schieber 15 angrenzt. Über den Abstand b ist mittig eine Heizzone (nicht dargestellt) angeordnet. Der Abstand c zwischen dem zweiten Flansch 4 und der mittig um die Kammer angeordneten Heizzone liegt in vorteilhafter Weise zwischen 60 mm und 130 mm. Dieser Abstand ist für die meisten Einsatzzwecke ausreichend.

## Patentansprüche

1. Kammer für eine chemische Dampfbeschichtung, die aus einem inneren Quarzrohr (1) besteht, das von einem kürzeren äußeren Quarzrohr (2) umgeben ist, bei der jedes Ende des inneren Quarzrohres (1) mit einem ersten Flansch (3) umgeben ist, der eine in Längsrichtung des inneren Quarzrohres (1) umlaufende Nut (3') aufweist, in der jeweils die Stirnseite des inneren Quarzrohres (1) positioniert ist, wobei zwischen dem ersten Flansch (3) und der Außenseite des inneren Quarzrohres (1 eine Dichtung (5') angeordnet ist, und bei der an dem jeweiligen ersten Flansch (3) in Richtung zur Rohrmitte ein zweiter Flansch (4) angeordnet ist, der eine umlaufende Kante (4') zur Fixierung der Stirnseite des kürzeren äußeren Quarzrohres (2) aufweist und der sowohl an der Außenseite des inneren Quarzrohres (1) als auch an der Außenseite des kürzeren äußeren Quarzrohres (2) anliegt, wobei zwischen dem zweiten Flansch (4) und der Außenseite des kürzeren äußeren Quarzrohres (2) eine Dichtung (5) angeordnet ist, und mindestens ein zweiter Flansch (4) mindestens einen verschließbaren Anschluß (14) aufweist, der mit dem Raum zwischen dem kürzeren äußeren Quarzrohr (2) und dem inneren Quarzrohr (1) verbunden ist, und bei der jeder erste Flansch (3) und jeder zweite Flansch (4) innen jeweils einen Kühlkanal (8,8') mit jeweils mindestens einem Einlaß und einem Auslaß für ein Kühlmedium aufweisen.

2. Kammer nach Anspruch 1, bei der mindestens ein erster Flansch (3) mindestens einen verschließbaren Anschluß (7) aufweist, der zur Innenseite des inneren Quarzrohres (1) verläuft.

3. Kammer nach Anspruch 1 oder Anspruch 2, bei der zwischen dem zweiten Flansch (4) und der Außenseite des kürzeren äußeren Quarzrohres (2) mindestens an einer Stelle eine Schicht (12) aus Polytetrafluorethylen angeordnet ist.

4. Kammer nach einem der Ansprüche 1 bis 3, bei der die Abstände a zwischen der Stirnseite des inneren Quarzrohres (1) und der an der gleichen Seite der Kammer verlaufenden Stirnseite des kürzeren äußeren Quarzrohres (2) an beiden Seiten der Kammer jeweils gleich groß sind.

5. Kammer nach einem der Ansprüche 1 bis 4, bei der der Abstand c zwischen dem jeweiligen zweiten Flansch (4) und der mittig um die Kammer angeordneten Heizzone im Bereich von 60 mm bis 130 mm liegt.

6. Kammer nach einem der Ansprüche 1 bis 5, bei der der erste Flansch (3) an mindestens einer Stelle einen parallel zur Längsrichtung des inneren Quarzrohres (1) beweglich geführten Bolzen (9) mit einer am ersten Flansch (3) außen anliegenden Druckfeder aufweist, der mit einem benachbarten Anschlußflansch (10) verbunden ist.

7. Kammer nach einem der Ansprüche 1 bis 6, bei der der erste Flansch (3) und der in Richtung zur Rohrmitte angeordnete zweite Flansch (4) als Einzelteil gefertigt sind und die Kühlkanäle (8,8') einen einzigen gemeinsamen Kühlkanal bilden.

8. Kammer nach einem der Ansprüche 1 bis 7, bei der in der umlaufenden Nut (3') eine weitere umlaufende Dichtung (5'') angeordnet ist.

## Claims

1. Chamber for chemical vapour deposition comprising an inner quartz tube (1) which is surrounded by a shorter outer quartz tube (2), where each end of the inner quartz tube (1) is encircled by a first flange (3) which has a peripheral groove (3') in the longitudinal direction of the inner quartz tube (1), in which groove is positioned the front side of the inner quartz tube (1), where between the first flange (3) and the outside of the inner quartz tube (1) is arranged a seal (5'), and on the first flange (3) in the direction towards the tube centre is arranged a second flange (4) which has a peripheral edge (4') for fixing the front face of the shorter outer quartz tube (2) and which lies both on the outside of the inner quartz tube (1) and on the outside of the shorter outer quartz tube (2), where between the second flange (4) and the outside of the shorter outer quartz tube (2) is arranged a seal (5), and at least one second flange (4) has at least one closable connection (14) which is connected with the space between the shorter outer quartz tube (2) and the inner quartz tube (1), and where each first flange (3) and each second flange (4) has on the inside a cooling channel (8, 8') each with at least one inlet and one outlet for a cooling medium.

2. Chamber according to claim 1 in which at least one first flange (3) has at least one closable connection (7) which runs towards the inside of the inner quartz tube (1).

3. Chamber according to claim 1 or claim 2, in which between the second flange (4) and the outside of the shorter outer quartz tube (2), at least at one point, is arranged a layer (12) of polytetrafluoroethylene.

4. Chamber according to any of claims 1 to 3, in which the distances a between the front face of the inner quartz tube (1) and the front face of the shorter outer quartz tube (2) running on the same side of the chamber are equally large on both sides of the chamber.

5. Chamber according to any of claims 1 to 4, in which the distance c between the second flange (4) and the heating zone arranged centrally about the chamber lies in the range of 60 mm to 130 mm.

6. Chamber according to any of claims 1 to 5, in which the first flange (3), at least at one point, has a bolt (9) movably guided parallel to the longitudinal direction of the inner quartz tube (1) with a compression spring lying on the outside of the first flange (3), which bolt is connected with an adjacent connection flange (10).

7. Chamber according to any of claims 1 to 6, in which the first flange (3) and the second flange (4) arranged in the direction towards the tube centre, are produced as a single component and the cooling channels (8, 8') form a single common cooling channel.

8. Chamber according to any of claims 1 to 7, in which in the peripheral groove (3') is arranged a further peripheral seal (5").

## Revendications

1. Chambre pour un dépôt chimique en phase vapeur, qui se compose d'un tube en quartz intérieur (1) entouré par un tube en quartz extérieur plus court (2), étant précisé que chaque extrémité du tube en quartz intérieur (1) est entourée par une première collerette (3) pourvue d'une rainure (3') qui s'étend dans le sens longitudinal du tube en quartz intérieur (1) et dans laquelle est positionné le côté frontal dudit tube en quartz intérieur (1), un joint d'étanchéité (5') étant disposé entre la première collerette (3) et le côté extérieur du tube en quartz intérieur (1), étant précisé aussi qu'il est prévu sur la première collerette (3), en direction du centre du tube, une seconde collerette (4) qui présente un bord périphérique (4') destiné à la fixation du côté frontal du tube en quartz extérieur plus court (2) et qui est appliquée à la fois contre le côté extérieur du tube en quartz intérieur (1) et contre le côté extérieur du tube en quartz extérieur plus court (2), un joint d'étanchéité (5) étant disposé entre la seconde collerette (4) et le côté extérieur du tube en quartz extérieur plus court (2), et au moins une seconde collerette (4) présentant au moins un raccordement (14) apte à être fermé qui est relié à l'espace situé entre le tube en quartz extérieur plus court (2) et le tube en quartz intérieur (1), et étant précisé enfin que chaque première collerette (3) et chaque seconde collerette (4) présentent, à l'intérieur, un canal de refroidissement (8, 8') avec au moins une admission et une sortie pour un agent de refroidissement.

2. Chambre selon la revendication 1, dans laquelle au moins une première collerette (3) présente au moins un raccordement (7) apte à être fermé qui s'étend vers le côté intérieur du tube en quartz intérieur (1).

3. Chambre selon la revendication 1 ou 2, dans laquelle il est prévu, entre la seconde collerette (4) et le côté extérieur du tube en quartz extérieur plus court (2), à au moins un endroit, une couche (12) de polytétrafluoréthylène.

4. Chambre selon l'une des revendications 1 à 3, dans laquelle les distances a entre le côté frontal du tube en quartz intérieur (1) et le côté frontal, situé sur le même côté de la chambre, du tube en quartz extérieur plus court (2), ont la même taille des deux côtés de la chambre.

5. Chambre selon l'une des revendications 1 à 4, dans laquelle la distance c entre la seconde collerette (4) et la zone chauffante disposée de manière centrée autour de la chambre est de l'ordre de 60 mm à 130 mm.

6. Chambre selon l'une des revendications 1 à 5, dans laquelle la première collerette (3) présente à au moins un endroit une tige (9) qui est mobile parallèlement au sens longitudinal du tube en quartz intérieur (1), qui est pourvue d'un ressort de compression appliqué contre l'extérieur de la première collerette (3) et qui est reliée à une collerette de raccordement voisine (10)

7. Chambre selon l'une des revendications 1 à 6, dans laquelle la première collerette (3) et la seconde collerette (4) disposée en direction du centre du tube sont réalisées sous la forme de pièces individuelles, et les canaux de refroidissement (8, 8') forment un seul canal de refroidissement commun.

8. Chambre selon l'une des revendications 1 à 7, dans laquelle un autre joint d'étanchéité périphérique (5") est disposé dans la rainure périphérique (3').
